# FASCICULE DE BREVET EUROPEEN

(11) **EP 1 185 955 B1**
(45) Date de publication et mention de la délivrance du brevet: **24.09.2003**
(21) Numéro de dépôt: 00922778.6
(22) Date de dépôt: 28.04.2000
(51) Int. Cl.: G06K 19/077

(54) **PROCEDE DE FABRICATION DE CARTES SANS CONTACT PAR LAMINAGE**
LAMINIERHERSTELLUNGSVERFAHREN EINER KONTAKTLOSEN KARTE
METHOD FOR MAKING CONTACTLESS CARDS BY LAMINATION

(30) Priorité: 29.04.1999 FR 9905479
(43) Date de publication de la demande: 13.03.2002
(73) Titulaire: SCHLUMBERGER Systèmes, 92120 Montrouge (FR)
(72) Inventeur: LIMELETTE, Yann, F-45430 Mardie (FR); EL YAMANI, Hayat, F-94240 L'Hay les Roses (FR); VOLPE, Pierre, F-45430 Mardie (FR)
(74) Mandataire: den Braber, Gerard Paul
(86) Numéro de dépôt international: FR0001136
(87) Numéro de publication internationale: WO00067199

(56) Documents cités:
- EP-A- 0 706 152
- EP-A- 0 737 935
- FR-A- 2 756 955

## Description

La présente invention concerne un procédé de fabrication d'objets portatifs au format carte et notamment de tels objets comportant, d'une part, un corps d'objet plastique composé de feuilles plastiques couvertes par des feuilles externes de recouvrement ou overlays et, d'autre part, une antenne dont les deux bornes sont connectées à des plots de connexion d'une puce à circuit intégré noyée dans le corps de carte.

Ces objets portatifs au format carte sont aptes à fonctionner sans contact électrique, au moyen d'un couplage inductif entre l'antenne du corps de carte et celle d'un lecteur associé. Ils sont utilisés, en particulier, en tant que titre de transport ou de badge d'accès à des locaux protégés.

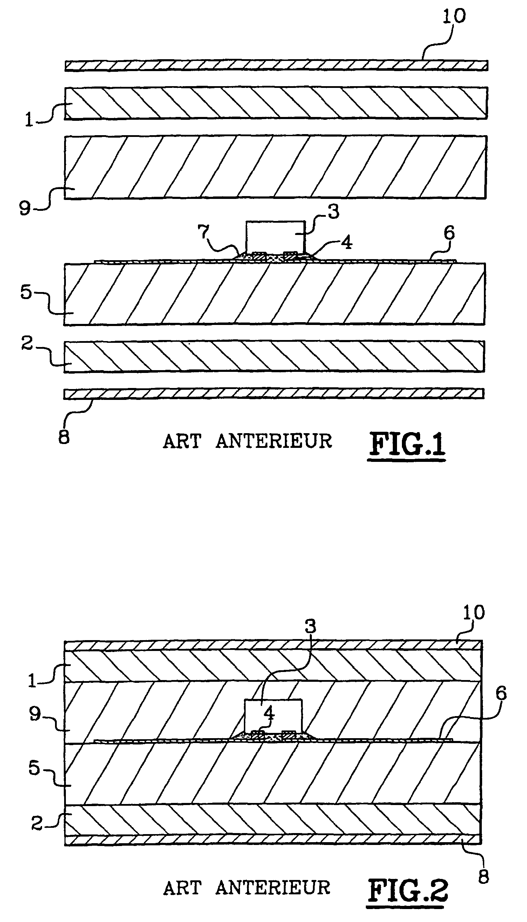

Pour leur fabrication, on procède classiquement de la manière illustrée aux figures 1 et 2 des dessins annexés.

Tout d'abord, on imprime des feuilles de polycarbonate (PC) en quadrichromie offset. Une première feuille 1 de PC est imprimée recto et une seconde feuille 2 est imprimée verso.

Par ailleurs, on reporte un nombre déterminé de puces 3, préalablement munies de protubérances 4, sur une feuille support 5 de polychlorure de vinyle (PVC) et de manière à connecter électriquement les plots de connexion de chacune desdites puces 3 aux bornes d'une antenne 6 sérigraphiée à la surface de la feuille support 5. Une résine de scellement 7 est alors déposée au lieu des connexions et à la face active de la puce 3.

Puis, après avoir sérigraphié une colle thermoactivable sur chaque feuille, on superpose, dans l'ordre indiqué ci-après : une première feuille externe de revêtement 8, la seconde feuille 2 de PC, la feuille support 5 portant la puce 3 et l'antenne 6, une feuille 9 d'incorporation de cette puce 3, la première feuille 1 de PC et une seconde feuille externe de revêtement 10. Les feuilles 5, 9, 8 et 10 sont des feuilles de PVC. On obtient alors un ensemble superposé dont les épaisseurs des différentes feuilles sont de l'ordre des suivantes
- première feuille externe de revêtement : 50 µm
- première feuille de PC : 150 µm
- feuille d'incorporation : 300 µm
- feuille de support : 190 µm
- puce : 260 µm
- seconde feuille de PC : 150 µm
- seconde feuille externe de revêtement : 50 µm

Cet ensemble est alors soumis à un premier puis à un second laminage à chaud selon des cycles de pression et de température définis. Notamment, le premier laminage, effectué à une température de l'ordre de 140°C, est destiné à coller les feuilles constitutives de l'ensemble par activation de la colle thermoactivable et à faire de sorte que les puces 3 s'incorporent dans la feuille d'incorporation 9 et le second laminage, effectué de même à une température de l'ordre de 140°C, est destiné à améliorer, d'une part, l'adhésion entre les différentes feuilles de l'ensemble et, d'autre part, l'état de surface dudit ensemble.

Ensuite, l'ensemble laminé est découpé et on obtient, au final, des objets portatifs au format carte tel que définis dans la norme ISO 7816-1, c'est-à-dire d'environ 0,760 mm d'épaisseur, de 85 mm de longueur et d'environ 54 mm de largeur.

Toutefois, le procédé décrit ci-dessus présente certains inconvénients.

Il nécessite la présence de deux matériaux thermoplastiques principaux : PC et PVC. Or, la température de transition vitreuse du PC, qui est de l'ordre de 150°C, est supérieure à la température de transition vitreuse du PVC, qui est seulement de l'ordre de 70°C. Le PC n'atteint donc pas sa température de transition vitreuse au cours des premier et second laminages. C'est la raison pour laquelle il est nécessaire de coller les différentes feuilles entre elles au moyen d'une colle.

De plus, la maîtrise de l'impression offset du PC est mal assurée, de même que la découpe de ce matériau plastique, à l'origine d'imperfections sur le champ des cartes.

Bien entendu, en vue de pallier les inconvénients du procédé décrit ci-dessus, on a imaginé remplacer les feuilles de PC par des feuilles de PVC. Toutefois, les cartes alors obtenues auraient montré, à leur surface et à la verticale au-dessus et au dessous de la puce, des défauts d'aspect consistant dans la présence de traces blanchâtres dues, à ces endroits, à une polymérisation/dépolymérisation du PVC des différentes feuilles de l'ensemble laminé et, en particulier, des feuilles de recouvrement, dans des conditions spécifiques différentes des conditions existantes dans le reste du corps de carte.

Notons que la demande de brevet EP 0 706 152 concerne une carte à puce à contacts comprenant une couche support. Une puce est montée sur la couche support selon la technique Flip chip. La puce est entourée par une couche coeur. La couche coeur est recouverte par une couche de recouvrement. L'ensemble ainsi formé est ensuite laminé dans une étape unique.

Aussi, compte tenu de ce qui précède, un problème que se propose de résoudre l'invention consiste dans la réalisation d'un procédé de fabrication d'un objet portatif au format carte comportant :
un corps d'objet comprenant une feuille support plastique, une feuille d'incorporation plastique ainsi qu'une première et une seconde feuilles externes de recouvrement ;
une antenne munie de deux bornes d'antenne ; et
une puce à circuit intégré munie de deux plots de connexion, ladite puce étant incorporée dans la feuille d'incorporation, chacun desdits deux plots de connexion étant connecté électriquement à une borne d'antenne ; ledit procédé comportant l'étape suivante selon laquelle
on reporte la puce sur la feuille support ;
procédé qui pallie les inconvénients ci-dessus et, notamment, permet d'éviter l'emploi de PC sans pourtant que les cartes obtenues présentent des défauts d'aspect.

Considérant ce problème, la solution de l'invention a pour premier objet un procédé du type précité caractérisé en ce qu'il comporte les étapes suivantes selon lesquelles :
on lamine la feuille support, sur laquelle on a reporté la puce, avec la feuille d'incorporation de manière à obtenir un premier ensemble laminé dans lequel la puce est incorporée dans la feuille d'incorporation ; et, dans un étape ultérieure,
on recouvre le premier ensemble laminé des première et seconde feuilles externes de recouvrement.

Ainsi, en procédant en deux étapes avec obtention d'un premier ensemble laminé PVC puis en recouvrant ce premier ensemble des feuilles de recouvrement, il est possible d'utiliser uniquement un même plastique pour la fabrication des feuilles de l'objet portatif au format carte, et notamment d'éviter l'emploi du PC, sans pour autant que la carte présente des défauts d'aspect.

L'exposé non limitatif qui suit permettra de mieux comprendre la manière dont l'invention peut être mise en pratique. Il est rédigé au regard des dessins annexés, dans lesquels :
- la figure 1 illustre, en coupe transversale éclatée, un procédé de fabrication d'une carte selon l'art antérieur ;
- la figure 2 montre, en coupe transversale, une carte obtenue selon un procédé de l'art antérieur ;
- la figure 3 illustre, en coupe transversale, une étape de laminage d'un procédé de fabrication d'une carte selon l'invention ;
- la figure 4 montre, en coupe transversale, le premier ensemble obtenu selon l'étape de laminage de l'invention ;
- la figure 5 illustre, en coupe transversale éclatée, une étape de laminage du premier ensemble avec des feuilles de recouvrement selon l'invention ; et
- la figure 6 illustre, en coupe transversale, une carte obtenue selon un procédé selon l'invention.

L'invention a pour objet la fabrication d'objets portatifs à puce au format carte. Ces objets sont notamment définis dans les normes ISO7810, ISO7816, dans le projet de norme ISO14443 et dans les normes ETSI/GSM11.11 et ESTI/GSM11.14

La fabrication de ces objets est avantageusement mise en oeuvre sur des feuilles de grandes dimensions. Par exemple, de telles feuilles ont une largeur de l'ordre de 22 cm et dont une longueur de l'ordre de 32 cm. Il est ainsi possible d'obtenir rapidement, après découpage, un nombre important de cartes. Dans l'exemple précité, ce nombre est de l'ordre de 10.

Toutefois, de manière à faciliter la lecture de l'exposé qui suit, l'invention est décrite essentiellement au regard de la fabrication d'une carte unique,

Selon l'invention, pour la fabrication d'une carte, on sérigraphie une antenne 11 à la surface d'une feuille support 12.

La feuille support 12 est plastique, notamment thermoplastique, avantageusement en PVC de température de transition vitreuse de l'ordre de 70°C. Son épaisseur est de l'ordre de 190 µm.

L'antenne 11 se présente par exemple sous la forme d'une spirale de trois spires d'une encre conductrice à base époxy chargée argent dont les extrémités constituent deux bornes 13 situées à proximité l'une de l'autre.

Dans une étape ultérieure, on reporte une puce 14 à circuit intégré sur les bornes 13 de l'antenne 11 de manière à connecter des plots 15 de contact de ladite puce 14, auxdites bornes 13 d'antenne 11.

Une telle puce 14 est sensiblement parallélépipèdique et rectangle de 260 µm d'épaisseur et de 2 mm de côté. Elle comporte une face active munie d'au moins deux plots 15 de contact. Ces plots 15 sont eux-mêmes munis de protubérances 16 ou bumps réalisés dans un polymère conducteur thermoplastique ou thermodurcissable tel qu'un polymère à base époxy chargé argent.

Une résine 17 de scellement est déposée sous forme liquide sur un côté de la puce 14 correspondant à sa face active. Cette résine de scellement migre par capillarité sous la puce 14, enrobe les éléments de connexion, c'est-à-dire les plots 15 de contact, les protubérances 16 ainsi que les bornes 13 d'antenne 11, et scelle la puce 14 à la feuille support 12.

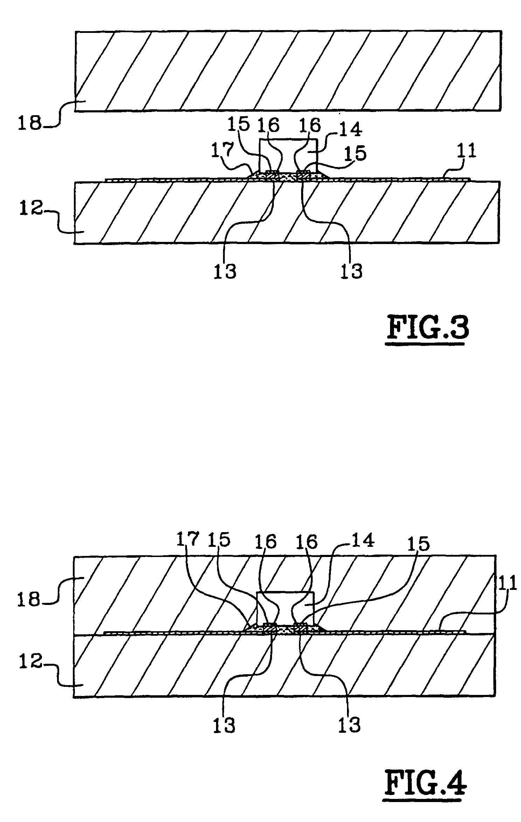

Par la suite, ainsi que cela est illustré à la figure 3. on superpose à la feuille support 12, sur laquelle on a reporté la puce 14, une feuille d'incorporation 18. Cette feuille 18 est une feuille plastique, notamment thermoplastique et avantageusement d'un thermoplastique ayant une température de transition vitreuse faible. Il s'agit en particulier de PVC dont la température de transition vitreuse est de l'ordre de 70°C.

L'ensemble superposé ainsi obtenu est alors, selon l'invention, laminé à une température de l'ordre de 140°C et sous pression selon un cycle déterminé. Par exemple, l'ensemble est soumis à une température de 140°C et à une pression de 10 bars pendant 10 minutes, puis la pression est augmentée pendant 7 minutes jusqu'à atteindre 100 bars où ladite pression est stabilisée pendant 4 minutes. La température est alors descendue à 20°C où l'ensemble est soumis à une pression de 200 bars pendant 18 minutes.

A la figure 4, on a montré le premier ensemble laminé alors obtenu. Dans ce premier ensemble, la puce 14 est incorporée à la feuille 18 d'incorporation, cette feuille 18 ayant en effet été portée à des conditions de température et de pression telle qu'elle a subi une fusion permettant l'intégration de ladite puce 14. Ce premier ensemble laminé est appelé inlet. Il peut être stocké et manipulé sans aucun risque pour la puce 14 ou pour l'antenne 11, ces éléments étant entièrement noyés dans ledit ensemble.

Dans une autre étape selon l'invention, une première 19 et une seconde 20 feuilles de recouvrement sont imprimées en quadrichromie offset et en images dites inverses, la première feuille 19, côté verso, et la seconde 20, côté recto. Ces feuilles 19, 20 sont plastiques, notamment thermoplastiques, avantageusement en PVC. Leur épaisseur est de l'ordre de 50 µm.

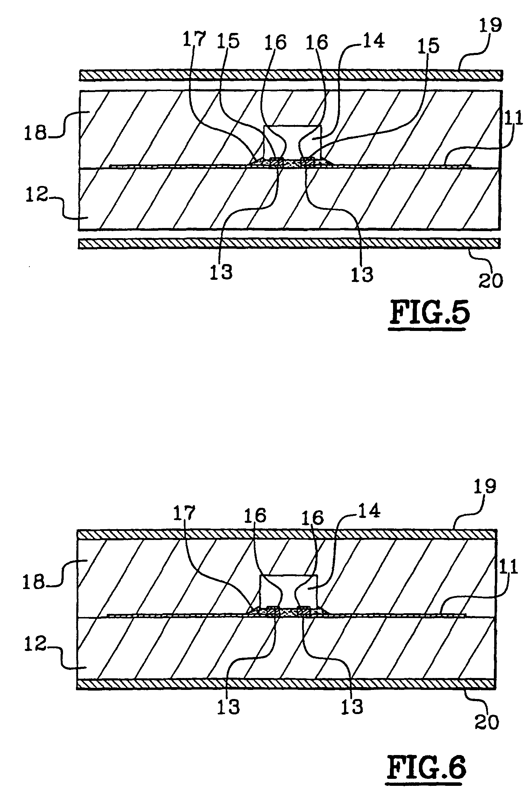

Ainsi que cela est illustré à la figure 5, le premier ensemble laminé est alors recouvert des deux feuilles 19, 20 de recouvrement. La première feuille 19 couvre directement la feuille d'incorporation 18 et la seconde feuille 20 couvre directement la feuille de support 12, les côtés imprimés desdites feuilles 19, 20 étant en contact avec lesdites feuilles 18, 12, respectivement. Cette étape selon laquelle on recouvre le premier ensemble laminé peut avantageusement s'accompagner d'un second laminage dudit premier ensemble avec les feuilles 19, 20. Ce second laminage est effectué selon un cycle de température et de pression du type précité permettant le soudage des deux feuilles de recouvrement avec le premier ensemble laminé. En pratique, la température atteinte au cours de ce cycle est de l'ordre de 140°C.

On obtient alors un second ensemble laminé qui peut être découpé au format carte.

Les cartes obtenues comportent et, en fait, comportent uniquement quatre épaisseurs principales constituées par les feuilles 19, 12, 18 et 20. une puce étant portée par la feuille 12 et incorporée dans la feuille 18. Toutes ces épaisseurs sont avantageusement constituées du même matériau plastique, le PVC.

## Revendications

1. Procédé de fabrication d'un objet portatif au format carte comportant :
un corps d'objet comprenant une feuille support (12) plastique, une feuille d'incorporation (18) plastique ainsi qu'une première (19) et une seconde (20) feuilles externes de recouvrement ;
une antenne (11) munie de deux bornes (13) d'antenne ; et
une puce (14) à circuit intégré munie de deux plots (15) de connexion, ladite puce (14) étant incorporée dans la feuille d'incorporation (18), chacun desdits deux plots (15) de connexion étant connecté électriquement à une borne (13) d'antenne ;
ledit procédé comportant l'étape suivante selon laquelle
on reporte la puce (14) et l'antenne (11) sur la feuille support (12) ; et
**caractérisé en ce qu'**il comporte en outre les étapes suivantes selon lesquelles :
on lamine la feuille support (12), sur laquelle on a reporté la puce (14), avec la feuille d'incorporation (18) de manière à obtenir un premier ensemble laminé dans lequel la puce (14) est incorporée dans la feuille d'incorporation (18) ; et, dans une étape ultérieure ;
on recouvre le premier ensemble laminé des première (19) et seconde (20) feuilles externes de recouvrement.

2. Procédé selon la revendication 1, **caractérisé en ce que** la feuille support (12), la feuille d'incorporation (18), les première (19) et seconde (20) feuilles externes de recouvrement sont thermoplastiques en polychlorure de vinyle.

3. Procédé selon l'une des revendications 1 ou 2, **caractérisé en ce que** la première feuille de recouvrement (19) couvre directement la feuille d'incorporation (18) et **en ce que** la seconde feuille de recouvrement (20) couvre directement la feuille support (12).

4. Procédé selon l'une des revendications 1, 2 ou 3, **caractérisé en ce que** l'étape selon laquelle on recouvre le premier ensemble laminé des première (19) et seconde (20) feuilles externes de recouvrement s'accompagne d'un laminage du premier ensemble laminé avec lesdites première (19) et seconde (20) feuilles de recouvrement.

## Patentansprüche

1. Verfahren zur Herstellung eines tragbaren Objektes im Kartenformat mit folgender Zusammensetzung :
ein Objektkörper bestehend aus einer Trägerfolie (12) aus Kunststoff, einer Einbringungsfolie (18) aus Kunststoff, sowie einer ersten (19) und zweiten (20) äusseren Deckfolie;
eine Antenne (11) mit zwei Antennenklemmen (13); und
ein elektronischer Chip (14) mit integrierter Schaltung und zwei Anschlusspunkten (15), wobei besagter Chip (14) in die Einbringungsfolie (18) integriert ist und jeder der beiden Anschlusspunkte (15) elektrisch mit je einer Antennenklemme (13) verbunden ist;
wobei besagtes Verfahren die folgende Etappe aufweist nach welcher:
der Chip (14) und die Antenne (11) auf die Trägerfolie (12) aufgetragen werden; und
**dadurch gekennzeichnet, dass** es zusätzlich die folgenden Etappen aufweist, nach welchen:
die Trägerfolie (12), auf welche der Chip (14) aufgetragen wurde, mit der Einbringungsfolie (18) so laminiert wird, dass sie ein erstes laminiertes Element bildet, in welches der Chip (14) in die Einbringungsfolie (18) integriert ist; und, in einer späteren Etappe
das laminierte Element mit der ersten (19) und der zweiten (20) Deckfolie überzogen wird.

2. Verfahren nach Anspruch 1, **dadurch gekennzeichnet, dass** die Trägerfolie (12), die Einbringungsfolie (18), sowie die erste (19) und die zweite (20) Deckfolie aus thermoplastischem Polyvinylchlorid bestehen.

3. Verfahren nach einem der Ansprüche 1 oder 2, **dadurch gekennzeichnet, dass** die erste Deckfolie (19) direkt auf der Einbringungsfolie (18) und die zweite Deckfolie (20) direkt auf der Trägerfolie (12) aufliegt.

4. Verfahren nach einem der Ansprüche 1, 2 oder 3, **dadurch gekennzeichnet, dass** anlässlich der Etappe in welcher das erste laminierte Element mit der ersten (19) und der zweiten (20) Deckfolie überzogen wird, das erste laminierte Element mit der ersten (19) und der zweiten (20) Deckfolie laminiert wird.

## Claims

1. Method of manufacturing a portable object in a card format comprising:
• an object body including a plastic support sheet (12), a plastic incorporation sheet (18), as well as a first external covering sheet (19) and a second external covering sheet (20);
• an antenna (11) provided with two antenna terminals (13), and
• an integrated circuit chip (14) provided with two connection pads (15), said chip (14) being incorporated in the incorporation sheet (18), each of said two connection pads (15) being electrically connected to one terminal (13) of the antenna,
said method comprising the following step according to which:
• the chip (14) and the antenna (11) are mounted on the support sheet (12), and **characterised in that** it further comprises the following steps according to which:
• the support sheet (12) on which the chip (14) has been mounted is rolled with the incorporation sheet (18) so as to obtain a first rolled assembly in which the chip (14) is incorporated in the incorporation sheet (18) ; and in a subsequent stage ;
• the first rolled assembly is covered with the first (19) and second (20) external covering sheets.

2. Method according to claim 1, **characterised in that** the support sheet (12), the incorporation sheet (18), and the first (19) and second (20) external covering sheets are made of thermoplastic, namely Polyvinyl Chloride.

3. Method according to claim 1 or 2, **characterised in that** the first covering sheet (19) directly covers the incorporation sheet (18) and **in that** the second covering sheet (20) directly covers the support sheet (12).

4. Method according to one of claims 1 2 to 3, **characterised in that** the stage in which the first rolled assembly is covered with the first (19) and second (20) external covering sheets is accompanied by a rolling of the first rolled assembly with said first (19) and second (20) covering sheets.
